# EUROPÄISCHE PATENTANMELDUNG

(11) **EP 4 601 423 A1**
(43) Veröffentlichungstag der Anmeldung: **13.08.2025**
(21) Anmeldenummer: 25156655.0
(22) Anmeldetag: 07.02.2025
(51) Int. Cl.: H05K 5/02, H05K 7/20, H01L 23/427, B60L 53/00

(54) **STEUERGERÄT, INSBESONDERE FAHRZEUGINTERNER LADER FÜR EIN ELEKTRISCH ANGETRIEBENES FAHRZEUG, VERFAHREN ZUR HERSTELLUNG DES STEUERGERÄTS UND VERFAHREN ZUM BETRIEB DES STEUERGERÄTS**

(30) Priorität: 07.02.2024 DE 102024103433
(71) Anmelder: Yazaki Systems Technologies GmbH, 93059 Regensburg (DE)
(72) Erfinder: CHOUDHURY, Nupur, 93049 Regensburg (DE); FRADCZYK, Rafael, 93105 Tegernheim (DE); CHAU, Thanh Qui, 93105 Tegernheim (DE); BÖHM, Markus, 90482 Nürnberg (DE)
(74) Vertreter: Patentanwaltskanzlei WILHELM & BECK

(57) **Zusammenfassung**

Die Erfindung betrifft ein Steuergerät (10), insbesondere einen fahrzeuginternen Lader (15) für ein elektrisch angetriebenes Fahrzeug, ein Verfahren zur Herstellung des Steuergeräts (10) und ein Verfahren zum Betrieb des Steuergeräts (10) aufweisend eine Steuereinrichtung (30) mit einer Wärmequelle (65), ein Gehäuse (35), einen Kühlkörper (40) und eine Verbindungsschicht (45), wobei in einem Gehäuseinnenraum (60) des Gehäuses (35) die Steuereinrichtung (30) angeordnet ist und an einer ersten Verbindungsseitenfläche (110) der Verbindungsschicht (45) anliegt, wobei der Kühlkörper (40) außerhalb des Gehäuseinnenraums (60) angeordnet ist und an einer zur ersten Verbindungsseitenfläche (110) gegenüberliegend angeordneten zweiten Verbindungsseitenfläche (115) der Verbindungsschicht (45) anliegt, wobei die Verbindungsschicht (45) thermisch und mechanisch die Steuereinrichtung (30) mit dem Kühlkörper (40) zur Kühlung der Wärmequelle (65) verbindet, wobei die Verbindungsschicht (45) ein Verbindungsmaterial aufweist, das ausgebildet ist, bei einer thermischen Überlastung der Steuereinrichtung (30) aus einem festen Phasenzustand aufzuschmelzen und die Steuereinrichtung (30) durch das Aufschmelzen vom festen Phasenzustand in einen flüssigen Phasenzustand zu kühlen.

## Beschreibung

Steuergerät, insbesondere fahrzeuginterner Lader für ein elektrisch angetriebenes Fahrzeug, Verfahren zur Herstellung des Steuergeräts und Verfahren zum Betrieb des Steuergeräts

Die Erfindung betrifft ein Steuergerät, insbesondere einen fahrzeuginternen Lader für ein elektrisch angetriebenes Fahrzeug gemäß Patentanspruch 1, ein Verfahren zur Herstellung des Steuergeräts gemäß Patentanspruch 13 und ein Verfahren zum Betrieb des Steuergeräts gemäß Patentanspruch 14.

Es sind fahrzeuginterne Lader für elektrisch angetriebene Kraftfahrzeuge bekannt. Der fahrzeuginterne Lader dient dazu, die an einem Ladeanschluss des Fahrzeugs bereitgestellte elektrische Energie, die zumeist als Wechselstrom bereitgestellt wird, in einen Gleichstrom zum Laden des elektrischen Energiespeichers, der insbesondere als Traktionsbatterie ausgebildet ist, umzuwandeln. Der fahrzeuginterne Lader weist dabei zahlreiche Komponenten, insbesondere Halbleiterbauelemente, auf, die sich im Betrieb erwärmen. Um die Erwärmung im Rahmen des Tolerierbaren zu halten, wird vorzugsweise der Lader aktiv gekühlt.

Es ist Aufgabe der Erfindung, ein verbessertes Steuergerät, insbesondere einen fahrzeuginternen Lader für ein elektrisch angetriebenes Kraftfahrzeug, bereitzustellen. Ferner ist es Aufgabe der Erfindung, ein verbessertes Verfahren zur Herstellung des Steuergeräts, insbesondere des fahrzeuginternen Laders, und ein verbessertes Verfahren zum Betrieb des Steuergeräts, insbesondere des fahrzeuginternen Laders, bereitzustellen.

Diese Aufgabe wird mittels der Merkmale des Anspruchs 1 sowie der Ansprüche 13 und 14 gelöst. Vorteilhafte Ausführungsformen sind in den abhängigen Ansprüchen angegeben.

Es wurde erkannt, dass ein verbessertes Steuergerät für ein Fahrzeug, insbesondere ein verbesserter fahrzeuginterner Lader für ein elektrisch angetriebenes Fahrzeug, dadurch bereitgestellt werden kann, dass das Steuergerät, insbesondere der fahrzeuginterne Lader, eine Steuereinrichtung mit einer Wärmequelle, ein Gehäuse, einen Kühlkörper und eine Verbindungsschicht aufweist. In einem Gehäuseinnenraum des Gehäuses ist die Steuereinrichtung angeordnet. An einer ersten Verbindungsseitenfläche der Verbindungsschicht liegt die Steuereinrichtung an. Der Kühlkörper ist außerhalb des Gehäuseinnenraums angeordnet und liegt an einer zur ersten Verbindungsseitenfläche gegenüberliegend angeordneten zweiten Verbindungsseitenfläche der Verbindungsschicht an. Die Verbindungsschicht verbindet thermisch und mechanisch die Steuereinrichtung mit dem Kühlkörper zur Kühlung der Wärmequelle. Zusätzlich kann die Verbindungsschicht auch einzelne Komponenten der Steuereinrichtung untereinander miteinander verbunden.

Die Verbindungsschicht weist ein Verbindungsmaterial auf, das ausgebildet ist, bei einer thermischen Überlastung der Steuereinrichtung aus einem festen Phasenzustand aufzuschmelzen und die Steuereinrichtung durch das Aufschmelzen vom festen Phasenzustand in einen flüssigen Phasenzustand zu kühlen.

Diese Ausgestaltung hat den Vorteil, dass auf weitere mechanische Befestigungsmittel zur Verbindung des Kühlkörpers mit der Steuereinrichtung verzichtet werden kann und auch eine sichere Wärmeübertragung zwischen dem Kühlkörper und der Steuereinrichtung, insbesondere der Wärmequelle der Steuereinrichtung, bereitgestellt werden kann.

Des Weiteren wird durch das Aufschmelzen der Verbindungsschicht im Überlastfall, beispielsweise wenn sich die Steuereinrichtung zumindest lokal auf eine Temperatur von größer 220°C erwärmt, ein weiterer Temperaturanstieg während des Aufschmelzens des Verbindungsmaterials verhindert, sodass zusätzliche Zeit geschaffen ist, um die Steuereinrichtung zu deaktivieren und ein Überhitzen oder eine weitere Beschädigung weiterer Komponenten der Steuereinrichtung zu verhindern.

In einer weiteren Ausführungsform weist das Steuergerät einen ersten Auffangbehälter auf, wobei der erste Auffangbehälter versetzt zu dem Kühlkörper angeordnet ist und ein erstes Auffangvolumen begrenzt, wobei der erste Auffangbehälter auf der zur Verbindungsschicht zugewandten Seite offen ausgestaltet und ausgebildet ist, aufgeschmolzenes Verbindungsmaterial der Verbindungsschicht aufzunehmen. Diese Ausgestaltung hat den Vorteil, dass eine Emission des Verbindungsmaterials in eine Umgebung oder in andere Bereiche des Fahrzeugs vermieden wird. Insbesondere wird eine Kontamination in die Umwelt des Fahrzeugs vermieden.

In einer weiteren Ausführungsform weist das Steuergerät eine Sensoreinrichtung mit wenigstens einem ersten Sensor auf. Der erste Sensor ist ausgebildet, das in dem ersten Auffangvolumen befindliche Verbindungsmaterial zu erfassen und in Abhängigkeit des erfassten Verbindungsmaterials ein Sensorsignal bereitzustellen. Das Sensorsignal kann beispielsweise der Steuereinrichtung bereitgestellt werden, sodass die Steuereinrichtung bei Erfassen von in dem ersten Auffangvolumen befindlichem Verbindungsmaterial sich deaktiviert oder deaktiviert wird und dadurch eine weitere Erhitzung der Steuereinrichtung vermieden wird, um eine weitere Schädigung des Steuergeräts zu vermeiden.

Von besonderem Vorteil ist hierbei, wenn der erste Sensor in dem ersten Auffangvolumen angeordnet ist. Auch wäre möglich, dass der erste Sensor außerhalb des ersten Auffangbehälters angeordnet ist. Zusätzlich oder alternativ kann der erste Sensor in die Verbindungsschicht eingebettet sein. Der erste Sensor kann beispielsweise sensitiv auf das Verbindungsmaterial sein.

In einer weiteren Ausführungsform ist das Verbindungsmaterial der Verbindungsschicht im Wesentlichen zerstörungsfrei reversibel aus dem festen Phasenzustand in den flüssigen Phasenzustand überführbar. Ein Schmelzpunkt des Verbindungsmaterials kann dabei in einem Bereich von einschließlich °60C bis einschließlich 120°C liegen. Durch einen Schmelzpunkt in diesem angegebenen Bereich eignet sich das Verbindungsmaterial als Phasenwechselmaterial und/oder als Latent-Wärmespeicher.

In einer weiteren Ausführungsform weist die Verbindungsschicht wenigstens eines der folgenden Verbindungsmaterialien auf: aliphatischen Kohlenwasserstoff, vorzugsweise mit 16 oder 17 oder 18 Kohlenstoffatomen, Salz, mikroverkapseltes Hartparaffin, Hartparaffin, Wachs, Naturwachs, thermochemischen Wärmespeicher. Zusätzlich oder alternativ weist die Verbindungsschicht wenigstens eines der folgenden Versteifungsmaterialien auf, das in dem Verbindungsmaterial eingebettet ist: Aluminiumnitrid (AIN), Faserwerkstoff (vorzugsweise mit langen und/oder kurzen Fasern) wie Basalt, Kohlenstoff, Nylon, Hanf, Flachs, Aramid und/oder Glasfaser (vorzugsweise mit langen und/oder kurzen Fasern)), merzerisierte Zellulose, pflanzliches Pulver, Kohlenstoff-Nanofilament, Zellulose-Nanofilament, Nanozellulose Mikrofibrille, Nanofibrille. Ein Anteil von pflanzlichem Pulver kann bis zu 74 Volumenprozent betragen. Alternativ dazu kann ein Anteil von Mikrofibrille bis zu 91 Volumenprozent betragen.

In einer weiteren Ausführungsform weist das Gehäuse eine Durchgangsöffnung auf, wobei der Kühlkörper an der Durchgangsöffnung angeordnet ist und die Verbindungsschicht die Durchgangsöffnung fluidisch abdichtet. Diese Ausgestaltung hat den Vorteil, dass auf zusätzliche Dichtmittel verzichtet werden kann. Insbesondere kann auf zusätzliche Gehäusedeckel umlaufende Dichtungen und mechanische Mittel, um den Gehäusedeckel an dem Gehäuse zu befestigen, verzichtet werden, sodass das Steuergerät durch die Abdichtung an der Durchgangsöffnung mittels der Verbindungsschicht besonders einfach und kostengünstig ausgebildet ist.

In einer weiteren vorteilhaften Ausführungsform ist der Kühlkörper, vorzugsweise ausschließlich, stoffschlüssig mittels der Verbindungsschicht mechanisch an der Steuereinrichtung befestigt. Die Steuereinrichtung ist ihrerseits in dem Gehäuse befestigt. Dies kann beispielsweise auch durch die Verbindungsschicht erfolgen. Diese Ausgestaltung hat den Vorteil, dass somit der Kühlkörper nur indirekt mit dem Gehäuse verbunden ist. Auf weitere mechanische Verbindungsmittel, insbesondere Schrauben, Klemmmittel oder Ähnliches, kann verzichtet werden oder diese können in reduzierter Anzahl vorgesehen sein

In einer weiteren Ausführungsform verschließt der erste Auffangbehälter zumindest abschnittweise die Durchgangöffnung.

In einer weiteren Ausführungsform weist das Gehäuse eine Gehäuseunterseite auf, wobei an der Gehäuseunterseite der Kühlkörper angeordnet ist. Die Verbindungsschicht ist unterhalb an der Steuereinrichtung angeordnet. Der Kühlkörper ist unterhalb an der Verbindungsschicht angeordnet. Der Kühlkörper ist ausgebildet, bei einem Aufschmelzen des Verbindungsmaterials der Verbindungsschicht sich zu lösen und sich von der Steuereinrichtung zu trennen. Diese Ausgestaltung hat den Vorteil, dass in einem Schadensfall des Steuergeräts, wenn die Steuereinrichtung so viel Abwärme produziert, dass die Verbindungsschicht aufschmilzt, und die aufschmelzende Verbindungsschicht die Steuereinrichtung im Schadensfall zu kühlen ist, durch die Abtrennung des Kühlkörpers eine zusätzliche Kühlung bereitgestellt wird, insbesondere wenn dabei die Durchgangsöffnung zu der Steuereinrichtung hin an der Gehäuseunterseite geöffnet wird.

In einer weiteren Ausführungsform weist das Steuergerät einen zweiten Auffangbehälter mit einem zweiten Auffangvolumen auf, wobei der zweite Auffangbehälter versetzt zu dem ersten Auffangbehälter und dem Kühlkörper angeordnet ist. Der zweite Auffangbehälter begrenzt das zweite Auffangvolumen. Der zweite Auffangbehälter ist auf der zur Verbindungsschicht zugewandten Seite offen ausgestaltet und ist ausgebildet, aufgeschmolzenes Verbindungsmaterial der Verbindungsschicht aufzunehmen. Diese Ausgestaltung hat den Vorteil, dass die Verbindungsschicht besonders dick ausgestaltet sein kann und dadurch eine gute elektrische Isolierung zwischen dem Kühlkörper und der Steuereinrichtung bereitgestellt werden kann. Das Verbindungsmaterial der Verbindungsschicht kann im Schadensfalle, also wenn das Verbindungsmaterial aufgeschmolzen wird, sowohl durch den ersten Auffangbehälter als auch durch den zweiten Auffangbehälter in hinreichender Menge aufgefangen werden, sodass eine Kontamination einer Umgebung des Fahrzeugs oder eines Innenraums des Fahrzeugs vermieden werden kann.

In einer weiteren Ausführungsform weist die Verbindungsschicht eine Freifläche auf, die auf einer der Steuereinrichtung abgewandten Seite angeordnet ist. Die Freifläche ist seitlich beabstandet zu dem Kühlkörper und vorzugsweise zu dem ersten Auffangbehälter angeordnet. Die Freifläche ist unbedeckt. Diese Ausgestaltung hat den Vorteil, dass im Reparaturfalle über die Freifläche eine thermische Energie, beispielsweise mittels Laserstrahlung, in die Verbindungsschicht eingeleitet werden kann, um die Verbindungsschicht aufzuschmelzen und den Kühlkörper von der Steuereinrichtung abzutrennen.

In einer weiteren Ausführungsform ist das Verbindungsmaterial in flüssigem Phasenzustand zerstörungsfrei reversibel von der Steuereinrichtung trennbar. Dadurch kann im Recycling der Steuereinrichtung eine Verunreinigung der Steuereinrichtung durch das Verbindungsmaterial vermieden werden.

In einer weiteren Ausführungsform ist nach der Trennung von der Steuereinrichtung das Verbindungsmaterial wiederverwendbar. Dadurch wird ein sortenreines Recycling des Verbindungsmaterials ermöglicht. Insbesondere kann das Verbindungsmaterial wieder eingesetzt werden um die Steuereinrichtung mit dem Kühlkörper zu verbinden.

Ein verbessertes Verfahren zur Herstellung des oben beschriebenen Steuergeräts wird dadurch bereitgestellt, dass die Steuereinrichtung in den Gehäuseinnenraum eingebracht wird. Das Verbindungsmaterial der Verbindungsschicht wird in flüssigem Phasenzustand auf die Steuereinrichtung aufgebracht. Der Kühlkörper wird an dem flüssigen Verbindungsmaterial angeordnet. Der Kühlkörper kühlt das flüssige Verbindungsmaterial ab, sodass das flüssige Verbindungsmaterial in den festen Phasenzustand zu der Verbindungsschicht überführt wird und die Verbindungsschicht den Kühlkörper mit der Steuereinrichtung thermisch und vorzugsweise mechanisch verbindet. Diese Ausgestaltung hat den Vorteil, dass auf zusätzliche Befestigungsmittel zur Verbindung des Kühlkörpers mit der Steuereinrichtung, insbesondere Schrauben, Klemmen oder Ähnliches, verzichtet werden kann und dadurch das Verfahren zur Herstellung des Steuergeräts, insbesondere des fahrzeuginternen Laders, besonders kostengünstig ist. Ferner kann durch die Verbindungsschicht und das mehrmals mögliche reversible Aufschmelzen und Abkühlen des Verbindungsmaterials ein gut reparierbares Steuergerät hergestellt werden, bei dem auf einfache Art und Weise der Kühlkörper abnehmbar ist.

Ein verbessertes Verfahren zum Betrieb des Steuergeräts, insbesondere des fahrzeuginternen Laders, kann dadurch bereitgestellt werden, dass in einem Regelbetrieb die Steuereinrichtung mit der Wärmequelle eine Wärme erzeugt, wobei im Regelbetrieb die Wärmequelle eine erste Maximaltemperatur erreicht, die geringer ist als eine Schmelztemperatur des Verbindungsmaterials. Die Wärme wird über die Verbindungsschicht von der Wärmequelle zu dem Kühlkörper zur Kühlung der Wärmequelle abgeführt. In einem Fehlerfall erwärmt die Wärmequelle sich auf eine zweite Maximaltemperatur, die größer ist als die Schmelztemperatur des Verbindungsmaterials. Das Verbindungsmaterial schmilzt auf und wird und in den flüssigen Phasenzustand überführt. Das flüssige Verbindungsmaterial fließt in das erste Auffangvolumen. Das Verfahren hat den Vorteil, dass frühzeitig das Aufschmelzen mittels einer Sensoreinrichtung beispielsweise erfasst werden kann und dadurch bei Erfassen des Aufschmelzens und dem Vorhandensein des flüssigen Verbindungsmaterials in dem ersten Auffangvolumen die Steuereinrichtung deaktiviert werden kann, um eine weitere Wärmeentwicklung fehlerfrei zu vermeiden.

In einer weiteren Ausführungsform wird ein Vorhandensein von Verbindungsmaterial in dem ersten Auffangvolumen überprüft. Bei Erfassen von Verbindungsmaterial in dem ersten Auffangvolumen wird das Steuergerät deaktiviert. Dadurch kann schnell ein Überhitzen des Steuergeräts unterbunden werden.

Nachfolgend wird die Erfindung anhand von Figuren näher erläutert. Dabei zeigen:
- Figur 1: eine perspektivische Darstellung eines Steuergeräts für ein Kraftfahrzeug;
- Figur 2: eine weitere perspektivische Darstellung des in Figur 1 gezeigten Steuergeräts;
- Figur 3: eine schematische Darstellung einer Schnittansicht entlang einer in Figur 1 gezeigten Schnittebene A-A durch das in Figur 1 gezeigte Steuergerät;
- Figur 4A: einen perspektivischen Ausschnitt einer Darstellung des in den Figuren 1 bis 3 gezeigten Steuergeräts;
- Figur 4B: eine perspektivische Darstellung des in den Figuren 1 bis 3 gezeigten Steuergeräts;
- Figur 5: ein Ablaufdiagramm eines Verfahrens zur Herstellung des in den Figuren 1 bis 4 gezeigten Steuergeräts;
- Figur 6A: eine schematische Seitenansicht der Steuereinrichtung;
- Figur 6B: eine Draufsicht auf die Steuereinrichtung vor einem ersten Verfahrensschritt;
- Figur 7: eine schematische Darstellung der Steuereinrichtung und des Gehäuses während eines dritten Verfahrensschritts;
- Figur 8: eine schematische Darstellung des Steuergeräts während eines vierten Verfahrensschritts; und
- Figur 9: einen Ausschnitt einer perspektivischen Unteransicht des in den Figuren 1 bis 4 gezeigten Steuergeräts.

In den nachfolgenden Figuren wird zum erleichterten Verständnis auf ein Koordinatensystem verwiesen. Das Koordinatensystem weist eine x-Achse (Längsrichtung), eine y-Achse (Querrichtung) und eine z-Achse (Höhenrichtung) auf. Das Koordinatensystem ist dabei beispielhaft als Rechtssystem ausgebildet.

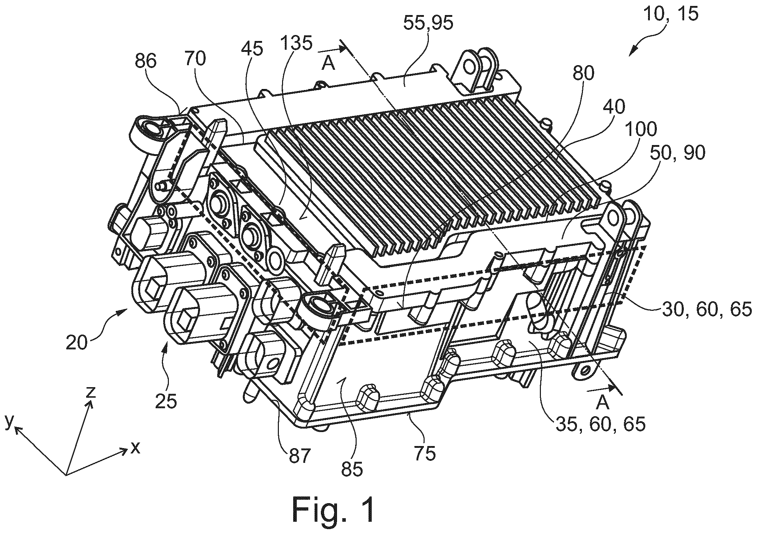

Figur 1 zeigt eine perspektivische Darstellung eines Steuergeräts 10 für ein Kraftfahrzeug.

Das Steuergerät 10 ist in der Ausführungsform beispielhaft als fahrzeuginterner Lader 15 für ein elektrisches angetriebenes Fahrzeug ausgebildet. Das Fahrzeug kann beispielsweise als Hybridfahrzeug oder als vollelektrisches Fahrzeug mit einem elektrischen Energiespeicher (nicht in Figur 1 dargestellt) zur Bereitstellung einer Antriebsenergie zum Antrieb des Fahrzeugs ausgebildet sein.

Der fahrzeuginterne Lader 15 weist eine Eingangsseite 20, eine Ausgangsseite 25 und eine Steuereinrichtung 30 (in Figur 1 strichliert schematisch angedeutet) auf.

Das Gehäuse 35 begrenzt einen Gehäuseinnenraum 60. In dem Gehäuseinnenraum 60 ist zumindest die Steuereinrichtung 30 angeordnet. Die Steuereinrichtung 30 kann dabei eine Leistungselektronik aufweisen. Die Steuereinrichtung 30 umfasst beispielhaft wenigstens eine Wärmequelle 65, die im Betrieb der Steuereinrichtung 30 eine Wärme erzeugt.

Die Wärme ist zum Schutz der Steuereinrichtung 30 aus dem Gehäuseinnenraum 60 und von der Steuereinrichtung 30 abzutransportieren, um eine Überhitzung der Steuereinrichtung 30 zu vermeiden.

Die Eingangsseite 20 und die Ausgangsseite 25 sind jeweils elektrisch mit der Steuereinrichtung 30 verbunden. Dabei kann die Eingangsseite 20 elektrisch beispielsweise mit einem Ladeanschluss (nicht in Figur 1 dargestellt) des Fahrzeugs verbunden sein. Die Ausgangsseite 25 kann beispielsweise elektrisch mit dem elektrischen Energiespeicher des Fahrzeugs verbunden sein. Bei Bereitstellung von elektrischer Energie, beispielsweise eines Wechselstroms, an dem Ladeanschluss wandelt die Steuereinrichtung 30 die bereitgestellte elektrische Energie beispielsweise in einen Gleichstrom um, der an der Ausgangsseite 25 zum Laden des elektrischen Energiespeichers bereitgestellt wird. Dabei erwärmt sich die Steuereinrichtung 30, insbesondere die Wärmequelle 65.

Das Gehäuse 35 weist beispielsweise eine Gehäuseoberseite 75 und eine in z-Richtung gegenüberliegend zur Gehäuseoberseite 75 angeordnete Gehäuseunterseite 80 auf. In Figur 1 ist dabei der Blick auf die Gehäuseunterseite 80 gerichtet. Die Gehäuseoberseite 75 und die Gehäuseunterseite 80 ergeben sich in eingebautem Zustand des Steuergeräts 10 im Fahrzeug. Dabei ist die Gehäuseunterseite 80 auf einer den Rädern zugewandten Seite angeordnet und die Gehäuseoberseite 75 auf einer den Rädern abgewandten Seite angeordnet. Die Gehäuseoberseite 75 und die Gehäuseunterseite 80 sind mittels Seitenflächen 85, 86, 87 jeweils miteinander verbunden, wobei beispielsweise die Eingangsseite 20 und die Ausgangsseite 25 an einer der Seitenflächen 85, 86, 87 angeordnet sein kann.

An der Gehäuseunterseite 80 weist das Gehäuse 35 eine Durchgangsöffnung 70 auf. Die Durchgangsöffnung 70 erstreckt sich vollständig durch die Gehäuseunterseite 80 und mündet in den Gehäuseinnenraum 60. Die Durchgangsöffnung 70 kann sich beispielsweise vollständig über die Gehäuseunterseite 80 erstrecken.

In Querrichtung an die erste Seitenfläche 85 anschließend ist der erste Auffangbehälter 50 angeordnet. In Querrichtung gegenüberliegend zu dem ersten Auffangbehälter 50 kann der zweite Auffangbehälter 55 an dem Gehäuse 35 angeordnet sein. Der zweite Auffangbehälter 55 reduziert beispielsweise einen Öffnungsquerschnitt der Durchgangsöffnung 70. Der erste Auffangbehälter 50 und der zweite Auffangbehälter 55 sind jeweils in z-Richtung an der Gehäuseunterseite 80 angeordnet. Dabei können der erste Auffangbehälter 50 und/oder der zweite Auffangbehälter 55 mechanisch mit dem Gehäuse 35, beispielsweise mittels einer Schraubverbindung, verbunden sein. Der erste Auffangbehälter 50 begrenzt auf einer dem Gehäuseinnenraum 60 zugewandten Seite ein erstes Auffangvolumen 90. Ferner kann der zweite Auffangbehälter 55 auf einer dem Gehäuseinnenraum 60 zugewandten Seite ein zweites Auffangvolumen 95 begrenzen. Sowohl der erste Auffangbehälter 50 als auch der zweite Auffangbehälter 55 können dabei schalenartig oder wannenartig ausgebildet sein. Das erste Auffangvolumen 90 und das zweite Auffangvolumen 95 münden an der Durchgangsöffnung 70.

Von besonderem Vorteil ist, wenn der erste Auffangbehälter 50 im Wesentlichen bündig zu einer ersten Seitenfläche 85 und der zweite Auffangbehälter 55 in Querrichtung gegenüberliegend zum ersten Auffangbehälter 50 bündig zu einer zweiten Seitenfläche 86 angeordnet ist.

In Querrichtung wird die von unten her sichtbare Durchgangsöffnung 70 in ihrer Querschnittsfläche durch den ersten Auffangbehälter 50 und den zweiten Auffangbehälter 55 limitiert. Dabei ist in der Ausführungsform beispielhaft der Kühlkörper 40 seitlich versetzt zu dem ersten Auffangbehälter 50 und dem zweiten Auffangbehälter 55 angeordnet. Insbesondere kann dabei der Kühlkörper 40 zwischen dem ersten Auffangbehälter 50 und dem zweiten Auffangbehälter 55 derart angeordnet sein, dass beispielsweise nur ein geringer Spalt 100 zwischen dem ersten Auffangbehälter 50 und dem Kühlkörper 40 und/oder dem zweiten Auffangbehälter 55 und dem Kühlkörper 40 angeordnet ist. Auch eine spaltfreie Anordnung des Kühlkörpers 40 zwischen dem ersten Auffangbehälter 50 und dem Kühlkörper 40 und/oder dem Kühlkörper 40 und dem zweiten Auffangbehälter 55 wäre möglich.

Zusätzlich kann die Verbindungsschicht 45 eine Freifläche 135 aufweisen. Die Freifläche 135 kann beispielsweise in Querrichtung zwischen dem ersten Auffangbehälter 50 und dem zweiten Auffangbehälter 55 angeordnet sein. In Längsrichtung befindet sich die Freifläche 135 in Figur 1 beispielhaft zwischen dem Kühlkörper 40 und der ersten Seitenfläche 85. Die Freifläche 135 zeichnet sich dadurch aus, dass an der Freifläche 135 die Verbindungsschicht 45 unbedeckt ist und offen an dem Steuergerät 10 vorliegt. An der Freifläche 135 kann der Spalt 100 enden. Die Freifläche 135 ist in Längsrichtung breiter ausgebildet als eine maximale Spaltbreite des Spalts 100. Die Freifläche 135 ist durch die Anordnung zwischen dem ersten und zweiten Auffangbehälter 50, 55 seitlich versetzt zu dem Auffangbehälter 50, 55 sowie zu dem Kühlkörper 40 angeordnet.

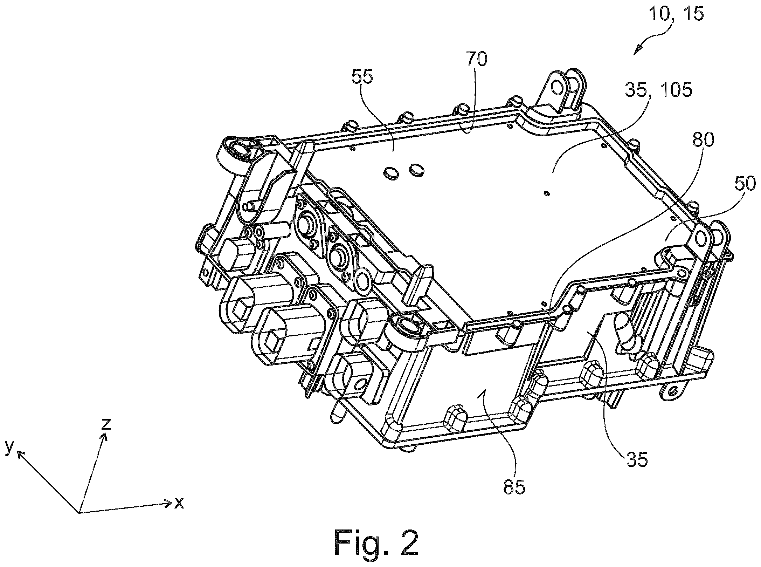

Figur 2 zeigt eine weitere perspektivische Darstellung auf des in Figur 1 gezeigten Steuergeräts 10, insbesondere des fahrzeuginternen Laders 15, mit Blickrichtung auf die Gehäuseunterseite 80 des Gehäuses 35 des Steuergeräts 10.

In Figur 2 wird auf die Darstellung der Auffangbehälter 50, 55 und den Kühlkörper 40 verzichtet. In Figur 2 ist deutlich zu erkennen, dass sich die Durchgangsöffnung 70 in Querrichtung im Wesentlichen vollständig über die Gehäuseunterseite 80 erstreckt. Auch kann die Durchgangsöffnung 70 in Längsrichtung sich vollständig über die Gehäuseunterseite 80 des Gehäuses 35 erstrecken.

Die Steuereinrichtung 30 schließt sich in z-Richtung an die Gehäuseunterseite 80 und an die Durchgangsöffnung 70 an. Insbesondere kann die Steuereinrichtung 30 sich im Wesentlichen über die gesamte Querschnittsfläche der Durchgangsöffnung 70 erstrecken. Die Steuereinrichtung 30 kann beispielsweise eine Leiterplatte 105 aufweisen. Die Leiterplatte 105 kann die Wärmequelle 65 tragen und elektrisch verbinden. Insbesondere kann an der Leiterplatte 105 die Wärmequelle 65 auf einer der Durchgangsöffnung 70 abgewandten Seite angeordnet sein. Auf der zur Gehäuseunterseite 80 und somit zur Durchgangsöffnung 70 zugewandten Seite kann die Leiterplatte 105 beispielsweise im Wesentlichen plan ausgebildet sein. Die Leiterplatte 105 kann zumindest bereichsweise thermisch leitend ausgebildet sein.

Schematisch angedeutet mittels strichlierter Linien ist in Figur 2 gezeigt, wie durch den Auffangbehälter 50, 55 die Querschnittsfläche der Durchgangsöffnung 70, die zwischen dem und zweiten Auffangbehälter 50, 55 angeordnet ist, reduziert ist.

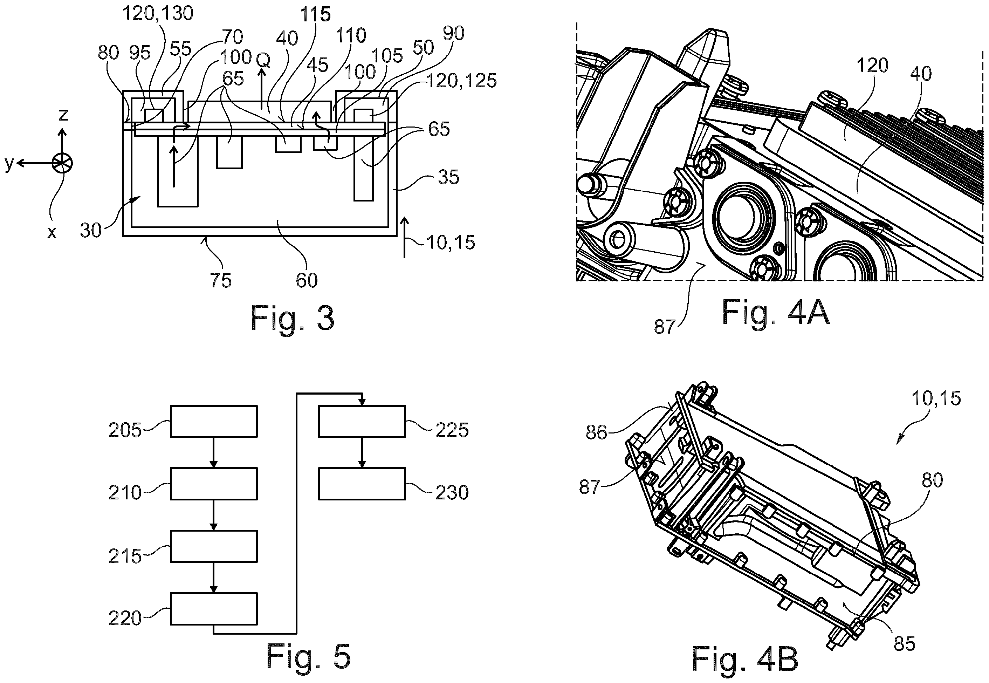

Figur 3 zeigt eine schematische Darstellung einer Schnittansicht entlang einer in Figur 1 gezeigten Schnittebene A-A durch das in Figur 1 gezeigte Steuergerät 10, insbesondere den fahrzeuginternen Lader 15. Wie beispielhaft in Figur 3 dargestellt, ist die Wärmequelle 65, die beispielsweise als elektronisches Bauteil, insbesondere als elektronisches Halbleiterbauelement, wie beispielsweise ein MOSFET, ausgebildet sein kann, auf der zur Gehäuseunterseite 80 abgewandten Seite und somit auf der zur Gehäuseoberseite 75 zugewandten Seite der Leiterplatte 105 angeordnet. Auf der zur Gehäuseunterseite 80 zugewandten Seite ist die Leiterplatte 105 durch die Verbindungsschicht 45 bedeckt, sodass die Leiterplatte 105 an einer ersten Verbindungsseitenfläche 110 anliegt. Insbesondere ist beispielsweise die Leiterplatte 105 stoffschlüssig mit der ersten Verbindungsseitenfläche 110 verbunden.

Der Kühlkörper 40 liegt an einer zweiten Verbindungsseitenfläche 115, die gegenüberliegend in z-Richtung zu der ersten Verbindungsseitenfläche 110 angeordnet ist, vorzugsweise vollflächig, an der Verbindungsschicht 45 an. Die zweite Verbindungsseitenfläche 115 kann im Wesentlichen plan ausgebildet sein. Ferner ist der Kühlkörper 40 mit der zweiten Verbindungsseitenfläche 115 stoffschlüssig verbunden. Dadurch dient die Verbindungsschicht 45 neben einer thermischen Anbindung der Steuereinrichtung 30 über die Verbindungsschicht 45 an dem Kühlkörper 40 auch zur mechanischen Befestigung des Kühlkörpers 40 an der Steuereinrichtung 30.

Die Steuereinrichtung 30 kann mit dem Gehäuse 35, beispielsweise durch eine Verschraubung der Leiterplatte 105, an dem Gehäuse 35 mechanisch befestigt sein. Durch die stoffschlüssige Anbindung des Kühlkörpers 40 über die Verbindungsschicht 45 mit der Steuereinrichtung 30, insbesondere der Leiterplatte 105, kann auf weitere mechanische Befestigungsmittel zur Befestigung des Kühlkörpers 40 an dem Gehäuse 35 verzichtet werden. Insbesondere wird hierbei auf ein Anschrauben des Kühlkörpers 40 an dem Gehäuse 35 verzichtet, sodass das Steuergerät 10, insbesondere der fahrzeuginterne Lader 15, besonders einfach herstellbar ist.

In einem Regelbetrieb des Steuergeräts 10, beispielsweise wenn das Steuergerät 10 als fahrzeuginterner Lader 15 den elektrischen Energiespeicher mit elektrischer Energie lädt, die an dem Ladeanschluss bereitgestellt wird, erwärmt sich die Wärmequelle 65. Die Wärmequelle 65 erzeugt eine Wärme Q beispielsweise aufgrund eines Ohm'schen Widerstands der Wärmequelle 65, beispielsweise wenn die Wärmequelle 65 als Halbleiterbauelement ausgebildet ist. Die Wärme Q wird über die wärmeleitende Leiterplatte 105 aus der Wärmequelle 65 abgeführt. Die Leiterplatte 105 kann beispielsweise als Wärmespreitzer dienen. Die Wärme Q wird von der Leiterplatte 105 an der ersten Verbindungsseitenfläche 110 in die Verbindungsschicht 45 eingeleitet. Die Verbindungsschicht 45 ist wärmeleitend ausgebildet und leitet die Wärme Q in Richtung des Kühlkörpers 40. Die Wärme Q tritt über die zweite Verbindungsseitenfläche 115 aus der Verbindungsschicht 45 aus und wird in den Kühlkörper 40 eingeleitet.

Der Kühlkörper 40 kann beispielsweise als passives Kühlelement mit Rippen ausgebildet sein, wobei die Wärme Q über Konvektion an eine Umgebung des Steuergeräts 10 abgegeben wird. Durch die Ausgestaltung des Kühlkörpers 40 als passives Kühlelement kann auf einen Anschluss des Steuergeräts 10, insbesondere des fahrzeuginternen Laders 15, an ein Flüssigkeitskühlsystem des Fahrzeugs verzichtet werden, sodass ein Montageaufwand des fahrzeuginternen Laders 15 zur Montage im Fahrzeug reduziert ist. Selbstverständlich wäre auch möglich, dass der Kühlkörper 40 als aktives Kühlelement und/oder als Wärmetauscher, dessen Sekundärseite in das Kühlsystem des Fahrzeugs eingebunden ist, ausgebildet sein kann.

Von besonderem Vorteil ist, wenn die Verbindungsschicht 45 wenigstens eines der folgenden Verbindungsmaterialien aufweist: aliphatische Kohlenwasserstoffe, vorzugsweise mit 16 oder 17 oder 18 Kohlenstoffatomen, Salz, mikroverkapseltes Hartparaffin, Hartparaffin, thermochemischen Wärmespeicher.

Zusätzlich kann in dem Verbindungsmaterial der Verbindungsschicht 45 wenigstens eines der folgenden Versteifungsmaterialien eingebettet sein: Aluminiumnitrid (AIN), Faserwerkstoff, wie Basalt, Kohlenstoff, Nylon, Hanf, Flachs, Aramid und/oder Glasfaser (vorzugsweise mit langen und/oder kurzen Fasern)), merzerisierte Zellulose, pflanzliches Pulver, Kohlenstoff-Nanofilament, Zellulose-Nanofilament, Nanozellulose Mikrofibrille, Nanofibrille. Ein Anteil von pflanzlichem Pulver kann bis zu 74 Volumenprozent betragen. Alternativ dazu kann ein Anteil von Mikrofibrille bis zu 91 Volumenprozent betragen. Aluminiumnitrit kann dabei einen Volumenanteil von einschließlich 5 % bis einschließlich 80 % aufweisen. Der Faserwerkstoff kann beispielsweise langfasrig und/oder kurzfasrig ausgebildet sein. Das Versteifungsmaterial ist dazu ausgebildet, ein E-Modul der Verbindungsschicht 45 gegenüber einem E-Modul des Verbindungsmaterials zu erhöhen und vorzugsweise eine Wärmeleitfähigkeit der Verbindungsschicht 45 gegenüber einer Wärmeleitfähigkeit des Verbindungsmaterials zu erhöhen. Dies hat den Vorteil, dass die Verbindungsschicht 45 mechanisch und thermisch besonders gut ausgebildet ist und somit sowohl eine gute mechanische als auch thermische Anbindung des Kühlkörpers 40 an der Steuereinrichtung 30 sichergestellt ist.

Von besonderem Vorteil ist, wenn die Leiterplatte 105 auf der zur Gehäuseunterseite 80 zugewandten Seite vorzugsweise vollflächig, aber zu wenigstens 80 %, mit der Verbindungsschicht 45 bedeckt ist. Insbesondere kann beispielsweise die Verbindungsschicht 45 sowohl in Längs- als auch in Querrichtung breiter ausgebildet sein als der Kühlkörper 40. So ragt in Querrichtung in Figur 3 die Verbindungsschicht 45 über den Kühlkörper 40 heraus und ist oberseitig des ersten und zweiten Auffangbehälters 50, 55 an der Durchgangsöffnung 70 zumindest teilweise durch die Verbindungsschicht 45 verschlossen. Dabei kann der Auffangbehälter 50, 55, insbesondere an der dem Kühlkörper 40 zugewandten Seite an der Verbindungsschicht 45 anliegen, sodass die Verbindungsschicht 45 die Durchgangsöffnung 70 zusammen mit dem Auffangbehälter 50, 55 fluiddicht verschließt und ein Eindringen einer Flüssigkeit, beispielsweise über den Spalt 100, in den Gehäuseinnenraum 60, insbesondere hin zur Steuereinrichtung 30, verhindert ist. Die fluiddichte Abdichtung durch die Verbindungsschicht 45 wird dadurch erzielt, dass die Verbindungsschicht 45 wenigstens eine Schichtdicke von einschließlich 0,8 mm bis einschließlich 10 mm aufweist und die Verbindungsschicht 45 geschlossen, das heißt unterbrechungsfrei und ohne eine Verbindung zwischen der ersten Verbindungsseitenfläche 110 hin zur zweiten Verbindungsseitenfläche 115, ausgebildet ist.

Zusätzlich kann das Steuergerät 10, insbesondere der fahrzeuginterne Lader 15, eine Sensoreinrichtung 120 aufweisen. Die Sensoreinrichtung 120 weist wenigstens einen ersten Sensor 125 und vorzugsweise einen zweiten Sensor 130 auf. Der erste Sensor 125 ist beispielsweise an dem ersten Auffangbehälter 50 in dem ersten Auffangvolumen 90 angeordnet. Selbstverständlich ist auch denkbar, dass der erste Sensor 125 auch außerhalb des ersten Auffangvolumens 90 angeordnet ist. Der zweite Sensor 130 kann in dem zweiten Auffangvolumen 95 angeordnet sein. Alternativ ist auch denkbar, dass der zweite Sensor 130 außerhalb des zweiten Auffangvolumens 95 angeordnet ist. Die Sensoreinrichtung 120 kann mit der Steuereinrichtung 30 datentechnisch und/oder elektrisch verbunden sein. Eine datentechnische Verbindung ist beispielsweise über einen CAN-Bus des Fahrzeugs möglich. Der erste Sensor 125 und/oder der zweite Sensor 130 sind direkt und/oder indirekt sensitiv auf das Verbindungsmaterial. Beispielsweise kann der erste Sensor 125 und/oder der zweite Sensor 130 als kapazitiver Sensor ausgebildet sein.

Figur 4A zeigt einen perspektivischen Ausschnitt einer Darstellung des in den Figuren 1 bis 3 gezeigten Steuergeräts 10. Figur 4B zeigt eine perspektivische Darstellung des in den Figuren 1 bis 3 gezeigten Steuergeräts 10, insbesondere des fahrzeuginternen Laders 15, wobei auf die Darstellung des Kühlkörpers 40 und der Auffangbehälter 50, 55 verzichtet wird.

Von besonderem Vorteil ist hierbei, wenn sich die Verbindungsschicht 45 in Querrichtung und Längsrichtung jeweils bis hin zu der Seitenfläche 85, 86, 86 erstreckt und dabei die Durchgangsöffnung 70 vollständig verschließt.

Die Verbindungsschicht 45 verschließt vorzugsweise eigenständig vollständig die Durchgangsöffnung 70. Dabei kann die Verbindungsschicht 45 Spalten, Risse oder Unterbrechungen in beispielsweise der Leiterplatte 105 und/oder zwischen der Leiterplatte 105 und dem Gehäuse 35 überbrücken.

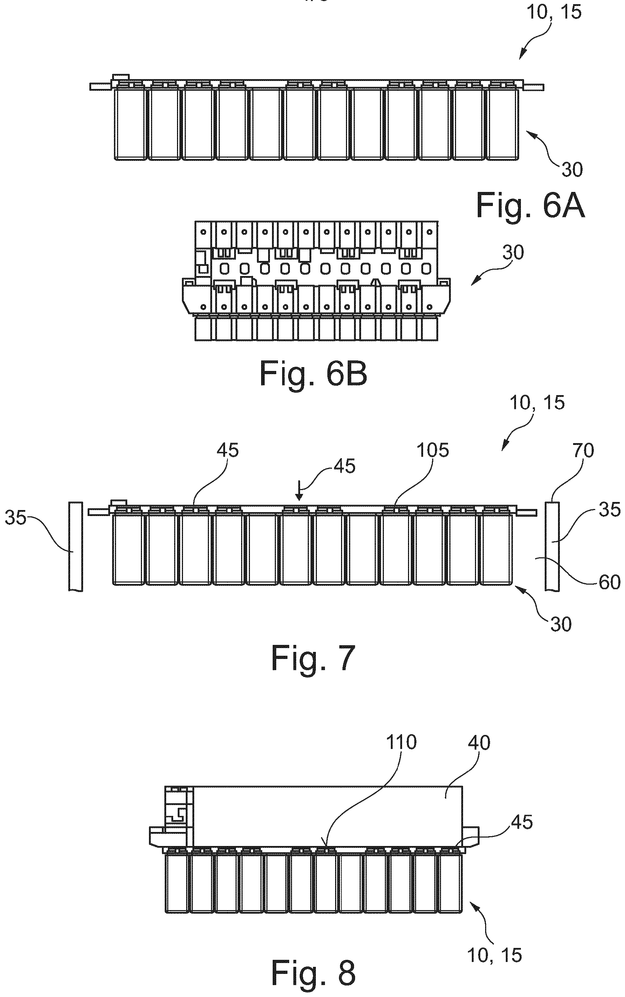

Figur 5 zeigt ein Ablaufdiagramm eines Verfahrens zur Herstellung des in den Figuren 1 bis 4 gezeigten Steuergeräts 10, insbesondere des fahrzeuginternen Laders 15. Figur 6A zeigt eine schematische Seitenansicht der Steuereinrichtung 30 und Figur 6B eine schematische Draufsicht auf die Steuereinrichtung 30 vor einem ersten Verfahrensschritt 205. Figur 7 zeigt eine schematische Darstellung der Steuereinrichtung 30 und des Gehäuses 35 während eines dritten Verfahrensschritts 215. Figur 8 zeigt eine schematische Darstellung des Steuergeräts 10 während eines vierten Verfahrensschritts 220.

In einem ersten Verfahrensschritt 205 wird die Steuereinrichtung 30 und vorzugsweise das Gehäuse 35 bereitgestellt (vgl. Figuren 6A, 6B).

In einem auf den ersten Verfahrensschritt 205 folgenden zweiten Verfahrensschritt 210 wird die Steuereinrichtung 30 in den Gehäuseinnenraum 60 eingesetzt. Zusätzlich kann die Steuereinrichtung 30 an dem Gehäuse 35 mechanisch befestigt werden. Die mechanische Befestigung kann beispielsweise mittels Verbindungsmitteln, wie beispielsweise Klemmen, Schrauben oder Ähnlichem, erfolgen.

In einem auf den zweiten Verfahrensschritt 210 folgenden dritten Verfahrensschritt 215 wird in flüssigem Phasenzustand das Verbindungsmaterial und gegebenenfalls das in dem Verbindungsmaterial eingebettete Versteifungsmaterial auf die Steuereinrichtung 30, insbesondere die Leiterplatte 105, aufgebracht (vgl. Figur 7). Der Auftrag der Verbindungsschicht 45 kann beispielsweise in einem Sprühauftrag auf die Steuereinrichtung 30, insbesondere auf die Leiterplatte 105, erfolgen. Zusätzlich können in dem Sprühauftrag und durch das in das Verbindungsmaterial eingebettete Versteifungsmaterial Spalten, Risse oder Öffnungen in der Leiterplatte 105 und/oder zwischen der Leiterplatte 105 und dem Gehäuse 35 überbrückt werden. Durch den Sprühauftrag kann dadurch besonders einfach und kostengünstig die Durchgangsöffnung 70 verschlossen werden und dadurch eine fluiddichte Abdichtung der Steuereinrichtung 30 in dem Gehäuseinnenraum 60 an der Durchgangsöffnung 70 gegenüber einer Umgebung sichergestellt werden.

In einem auf den dritten Verfahrensschritt 215 folgenden vierten Verfahrensschritt 220 (vgl. Figur 8) wird, vorzugsweise solange sich noch das Verbindungsmaterial in flüssigem Phasenzustand befindet, in definierten Abstand auf die Leiterplatte 105 in das aufgespritzte Verbindungsmaterial und das gegebenenfalls in das Verbindungsmaterial eingebettete Versteifungsmaterial der Kühlkörper 40 aufgesetzt (vgl. Figur 8). Dabei liegt vorzugsweise der Kühlkörper 40 vollflächig an der zweiten Verbindungsseitenfläche 115 an.

In einem auf den vierten Verfahrensschritt 220 folgenden fünften Verfahrensschritt 225, der auch zeitgleich zu dem vierten Verfahrensschritt 220 erfolgen kann, wird das bis dahin in flüssigem Phasenzustand vorliegende Verbindungsmaterial unter den Schmelzpunkt abgekühlt, sodass das Verbindungsmaterial in den festen Phasenzustand wechselt und die Verbindungsschicht 45 ausbildet.

Zusätzlich kann die Position des Kühlkörpers 40 während des Erstarrens des Verbindungsmaterials der Verbindungsschicht 45 dadurch gesichert werden, dass der Kühlkörper 40 beispielsweise mittels eines Roboterarms oder einer anderen Vorrichtung in definiertem Abstand zu der Leiterplatte 105 bzw. zu der Steuereinrichtung 30 gehalten wird.

Das Halten des Kühlkörpers 40 bzw. die fixe Positionierung des Kühlkörpers 40 in Relation zur Steuereinrichtung 30 wird erst dann aufgehoben, wenn das Verbindungsmaterial der Verbindungsschicht 45 zumindest teilweise, insbesondere überwiegend, vorzugsweise vollständig, erstarrt ist.

Insbesondere wird bei dem Abkühlen und Aushärten des Verbindungsmaterials das Versteifungsmaterial, sofern es während des Auftrags aufgebracht wird, in dem Verbindungsmaterial eingebettet, sodass das Versteifungsmaterial und das Verbindungsmaterial eine integriert ausgebildete Verbindungsschicht 45 ausbilden.

In einem auf den fünften Verfahrensschritt 225 folgenden sechsten Verfahrensschritt 230 wird der erste Auffangbehälter 50 und gegebenenfalls der zweite Auffangbehälter 55 an dem Gehäuse 35 befestigt. Die Befestigung kann beispielsweise mittels Klemmen oder Schrauben erfolgen. Zusätzlich ist auch denkbar, dass anstatt des sechsten Verfahrensschritts 230 der erste und/oder zweite Auffangbehälter 50, 55 während des vierten Verfahrensschritt 220 an dem Gehäuse 35 befestigt wird, sodass der Auffangbehälter 50, 55 an der zum Kühlkörper 40 zugewandten Seite in die noch flüssige Verbindungsschicht 45 eintaucht und dadurch eine fluiddichte Abdichtung an dem Auffangbehälter 50, 55 durch die Verbindungsschicht 45 ausgebildet wird.

Es wird betont, dass auf zusätzliche Verbindungsmittel zur Befestigung des Kühlkörpers 40, insbesondere für eine direkte mechanische Verbindung zwischen dem Kühlkörper 40 und dem Gehäuse 35, verzichtet wird und der Kühlkörper 40 nur indirekt über die Verbindungsschicht 45 und die Steuereinrichtung 30 mit dem Gehäuse 35 verbunden ist.

Wie bereits im Rahmen von Figur 3 erläutert, wird die Steuereinrichtung 30 im Regelbetrieb passiv durch die Wärmeübertragung der Wärme Q über die Verbindungsschicht 45 mittels des Kühlkörpers 40 gekühlt. Neben dem regulären Regelbetrieb kann auch ein Schadensfall auftreten. Im Schadensfall ist zu vermeiden, dass die Steuereinrichtung 30 und deren Komponenten weiter überhitzen. Insbesondere ist im Schadensfall für eine erhöhte Kühlung der Steuereinrichtung 30 zu sorgen, um weiteren Schaden von den Komponenten der Steuereinrichtung 30 abzuwenden und die üblicherweise relativ teure Steuereinrichtung 30 einfach reparieren zu können.

Tritt ein Schadensfall auf, erzeugt die Wärmequelle 65 eine erhöhte Menge der Wärme Q. Die Wärme Q sorgt dafür, dass sich die Wärmequelle 65 stark erhitzt und die Wärme Q über die Leiterplatte 105 an die Verbindungsschicht 45 übertragen wird. Die Wärme Q erwärmt die Verbindungsschicht 45 über den Schmelzpunkt des Verbindungsmaterials, sodass das Verbindungsmaterial aufgeschmolzen wird. Dabei wirkt das Verbindungsmaterial als Phasenwechselmaterial oder Latent-Wärmespeicher. Dabei wird während des Aufschmelzens weiter Wärme Q aufgenommen. Das Aufschmelzen der Verbindungsschicht 45 bewirkt, dass die Steuereinrichtung 30 zusätzlich gekühlt wird und eine Temperaturerhöhung (kurzzeitig) nicht erfolgt. Das aufgeschmolzene Verbindungsmaterial fließt in das erste und/oder zweite Auffangvolumen 90, 95 des Auffangbehälters 50, 55.

Das aufgeschmolzene Verbindungsmaterial und das gegebenenfalls in dem aufgeschmolzenen Verbindungsmaterial eingebettete Versteifungsmaterial fließt entlang des Kanals 145 in den ersten und/oder zweiten, im Ausgangslieferungszustand des Steuergeräts 10 leeren, Auffangbehälter 50, 55 und wird in dem ersten und/oder zweiten Auffangvolumen 90, 95 gespeichert. Dadurch dass der erste und/oder zweite Auffangbehälter 50, 55 nicht im Wärmefluss zwischen der Steuereinrichtung 30 und dem Kühlkörper 40 eingebunden ist, sondern versetzt zu dem Wärmefluss angeordnet ist, ist der Auffangbehälter 50, 55 im Regelfall, aber auch im Schadensfall deutlich kälter als der Kühlkörper 40 sowie die Wärmequelle 65. Dadurch kann das in den Auffangbehälter 50, 55 einfließende Verbindungsmaterial gegebenenfalls in dem Auffangvolumen 90, 95 erstarren.

Der Sensor 125, 130 erfasst das Vorhandensein von Verbindungsmaterial in dem jeweiligen zugehörigen Auffangvolumen 90, 95 und stellt in Abhängigkeit des erfassten Verbindungsmaterials ein entsprechendes Sensorsignal bereit, das durch die Steuereinrichtung 30 erfasst wird. Die Steuereinrichtung 30 unterbricht beispielsweise einen Ladevorgang und somit eine elektrische Verbindung zwischen der Eingangsseite 20 und der Ausgangsseite 25, wenn zumindest einer der beiden Sensoren 125, 130 Verbindungsmaterial in dem Auffangvolumen 90, 95 erfasst. Die Unterbrechung, beispielsweise des Ladevorgangs, zielt darauf ab, dass eine weitere Erhitzung der Wärmequelle 65 verhindert wird.

Dennoch kann im Schadensfall der Fall auftreten, dass die Wärmequelle 65 sich sehr schnell erwärmt und eine hohe Wärme Q bereitstellt. Die Wärme Q sorgt in diesem Fall dafür, dass die Verbindungsschicht 45 so weit aufgeschmolzen wird, dass die Verbindungsschicht 45 nicht mehr mechanisch den Kühlkörper 40 an der Steuereinrichtung 30 halten kann und der Kühlkörper 40 sich ablöst. Dadurch wird die Durchgangsöffnung 70 zwischen dem ersten und zweiten Auffangbehälter 50, 55 freigegeben, und die Steuereinrichtung 30 wird durch die über die Durchgangsöffnung 70 strömende Luft aus der Umgebung besonders stark gekühlt. Insbesondere wird dadurch eine weitere lokale Erhitzung, insbesondere ein gegebenenfalls beginnender Schwelbrand, in dem Gehäuseinnenraum 60 vermieden und eine Löschmöglichkeit zum Löschen der Steuereinrichtung 30 geschaffen. Des Weiteren wird durch die Steuereinrichtung 30 und das Erfassen der aufschmelzenden Verbindungsschicht 45 durch den ersten und/oder zweiten Sensor 125, 130 der Ladevorgang unterbrochen.

Der abfallende Kühlkörper 40 kann beispielsweise mittels eines Fangriemens gesichert sein. Alternativ ist auch denkbar, dass der Kühlkörper 40 in eine entsprechende Aufnahme, beispielsweise am Fahrzeugboden fällt.

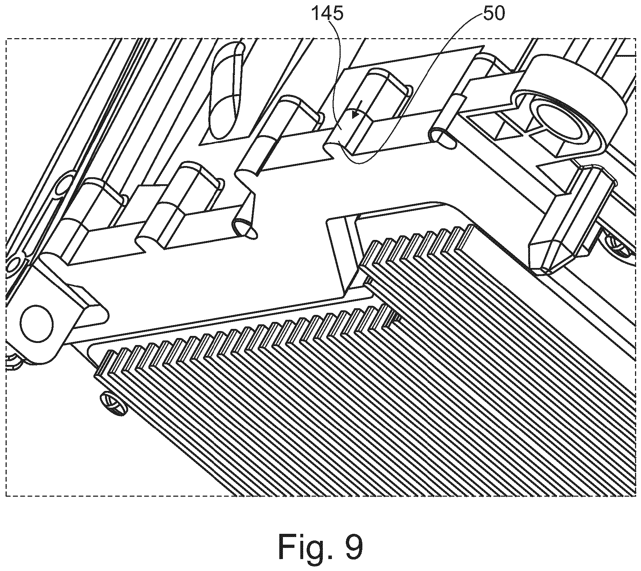

Figur 9 zeigt einen Ausschnitt einer perspektivischen Unteransicht des in den Figuren 1 bis 4 gezeigten Steuergeräts 10.

Von besonderem Vorteil ist, wenn, wie in Figur 9 gezeigt, das aufschmelzende Verbindungsmaterial anhand von im Auffangbehälter 50, 55 vorhandenen Kanälen 145 fließt, um so einen zuverlässigen Fluss hin zum Sensor 125, 130 sicherzustellen.

Die oben beschriebene Ausgestaltung hat den Vorteil, dass über die Verbindungsschicht 45 eine einfache und mechanische Befestigung des Kühlkörpers 40 an der Steuereinrichtung 30 sichergestellt werden kann. Die oben angegebenen Verbindungsmaterialien eignen sich auch besonders gut für die mechanische Verbindung des Kühlkörpers 40 mit der Steuereinrichtung 30, insbesondere der Leiterplatte 105, da diese schwingungsdämpfend sind und dadurch mechanische Schocks zwischen dem Kühlkörper 40 und der Steuereinrichtung 30 nur gedämpft und somit nur teilweise übertragen werden.

Des Weiteren werden durch die Wärmespeicherfähigkeit der Verbindungsschicht 45 thermische Schocks innerhalb der Steuereinrichtung 30 vermieden. Diese Ausgestaltung hat den Vorteil, dass die Leiterplatte 105 besonders großflächig ausgebildet sein kann, insbesondere einstückig und mehrlagig ausgebildet sein kann, ohne dass hierbei während des Regelbetriebs thermische Spannungen innerhalb der Leiterplatte 105 auftreten.

Die Verbindungsschicht 45 und die oben genannten Verbindungsmaterialien sind insbesondere gegenüber zahlreichen Chemikalien, Flüssigkeit, Feuchtigkeit resistent und stellen damit eine korrosionssichere Abdichtung des Gehäuseinnenraums 60 gegenüber der Umgebung sicher.

Durch die Verwendung der Verbindungsmaterialien wird ferner eine zusätzliche elektrische Isolierung der Leiterplatte 105 gegenüber dem Kühlkörper 40 und/oder dem Auffangbehälter 50, 55 sichergestellt, sodass diese beispielsweise aus einem elektrisch leitfähigen Material ausgebildet sein können und auf weitere elektrische Isolierungsmittel an der Leiterplatte 105 verzichtet werden kann.

Die thermische Leitfähigkeit kann mittels der oben angegebenen Versteifungsmaterialien zusätzlich erhöht werden. Insbesondere eignen sich Aluminiumnitride (AIN), die in das Verbindungsmaterial eingebettet sind, um die thermische Leitfähigkeit der Verbindungsschicht 45 zu erhöhen.

Um beispielsweise im Reparaturfall den Kühlkörper 40 leicht abzutrennen und beispielsweise die Steuereinrichtung 30 zu reparieren, kann über die Freifläche 135 (vgl. Figur 1) die Verbindungsschicht 45 beispielsweise mittels Laserstrahlung erwärmt und aufgeschmolzen werden, um den Kühlkörper 40 abzunehmen. Dadurch ist die Steuereinrichtung 30 besonders leicht zugänglich. Auch kann die aufgeschmolzene Verbindungsschicht 45 recycelt werden.

Die Verbindungsschicht 45 eignet sich insbesondere auch zur Verbesserung des Thermomanagements des Steuergeräts 10, insbesondere des internen Laders 15, da durch die oben genannte Verwendung von Verbindungsmaterialien, die hierbei als Wärmespeicher fungieren, eine thermische Regulation und Stabilisation für die Komponenten der Steuereinrichtung 30 während des Betriebs erfolgt.

Die mechanische Steifigkeit kann, wie oben erläutert, mittels der oben genannten Versteifungsmaterialien, insbesondere mittels des in das Verbindungsmaterial eingebetteten Versteifungsmaterials, erhöht werden.

Des Weiteren können Rüttelgeräusche vermieden werden, da die Verbindungsschicht 45 innerhalb des Steuergeräts 10 als mechanischer Vibrationsdämpfer wirkt.

Des Weiteren kann auf zusätzliche Verbindungsmittel, wie beispielsweise Tapes, Schnappverbindungen oder Schweißverbindungen, um die Steuereinrichtung 30 mit dem Kühlkörper 40 zu verbinden, verzichtet werden. Dadurch ist das Steuergerät 10, insbesondere der fahrzeuginterne Lader 15, besonders einfach herstellbar.

Des Weiteren ist das Steuergerät 10 besonders reparaturfähig, da die Verbindungsschicht 45 leicht durch ihr Aufschmelzen aufgetrennt und der Kühlkörper 40 abgenommen werden kann.

Des Weiteren kann eine Rekristallisation oder ein Wiedererstarren des Verbindungsmaterials, nachdem es verflüssigt worden ist, dazu genutzt werden, dass die beiden zu verbindenden Komponenten, die Steuereinrichtung 30 und der Kühlkörper 40, wiederverwendet werden können. Eine Wiederverwendung ist sogar mehrfach möglich.

Des Weiteren kann auf den Einsatz von Vergussmaterialien und/oder Schritten zum Vergießen der Steuereinrichtung 30 in dem Gehäuseinnenraum 60 verzichtet werden, sodass das Steuergerät 10 besonders schnell und kostengünstig hergestellt werden kann. Insbesondere ist dies für eine Großserienfertigung von Vorteil.

Des Weiteren kann auf eine Oberflächenbehandlung, insbesondere der Steuereinrichtung 30, gegenüber beispielsweise eintretenden Flüssigkeiten, Feuchtigkeit und zur Korrosionsvermeidung oder zum Schutz vor Chemikalien vermieden werden, sodass die Steuereinrichtung 30 besonders kostengünstig hergestellt werden kann.

Des Weiteren ist das oben beschriebene Verfahren zur Herstellung des Steuergeräts 10 zur Verbindung der Steuereinrichtung 30 mittels der Verbindungsschicht 45 mit dem Kühlkörper 40 besonders einfach.

Das Verbindungsmaterial der Verbindungsschicht 45 weist eine definierte Schmelztemperatur bzw. eine definierte Wiedererstarrungstemperatur auf, sodass gezielt diese

Temperaturen zur Verflüssigung bzw. zur Erstarrung des Verbindungsmaterials im Herstellungsverfahren und im Betriebsverfahren genutzt werden können. Ferner ist das Verhalten im Rahmen des Betriebs des Steuergeräts 10 sowohl im Regelfall als auch im Fehlerfall definiert und kontrolliert vorhersehbar.

Es wird darauf hingewiesen, dass, um die Nachhaltigkeit zu erhöhen, die Verbindungsmaterialien natürlichen Ursprungs sein können und insbesondere mit Bio-Qualität hergestellt werden können, sodass die Nachhaltigkeit des Steuergeräts 10 erhöht ist.

Dadurch kann auf Kunststoffe (sowohl recycelt als auch neu hergestellt) zur Verbindung des Kühlkörpers 40 mit der Steuereinrichtung 30 verzichtet werden und ferner wird dadurch eine Recycling-Fähigkeit des Steuergeräts 10 erhöht.

Von besonderem Vorteil ist, sollte an anderer Stelle des Steuergeräts 10 ebenso eine Verbindung notwendig sein, wenn das Verbindungsmaterial, das zur Verbindung des Kühlkörpers 40 mit der Steuereinrichtung 30 verwendet wird, auch an anderer Stelle eingesetzt werden kann, wodurch das Steuergerät 10 besonders einfach herzustellen und eine Recycling-Fähigkeit für das Steuergerät 10 besonders hoch ist.

Des Weiteren kann durch die oben genannten Verbindungsmaterialien auf die Zugabe von Additiven oder Katalysatoren zur Herstellung der fluiddichten Abdichtung der Durchgangsöffnung 70 und zur Sicherstellung der adhäsiven Eigenschaften der Verbindungsschicht 45 verzichtet werden.

Des Weiteren wird durch die elektrisch isolierenden Eigenschaften des Verbindungsmaterials eine elektrische Isolierung des Kühlkörpers 40 gegenüber dem Steuergerät 10, insbesondere gegenüber der Leiterplatte 105, sichergestellt.

Des Weiteren kann auf einen unterseitig angeordneten Gehäusedeckel verzichtet werden und der Gehäusedeckel durch die Verbindungsschicht 45 ersetzt werden.

### Bezugszeichenliste

- 10: Steuergerät
- 15: fahrzeuginterner Lader
- 20: Eingangsseite
- 25: Ausgangsseite
- 30: Steuereinrichtung
- 35: Gehäuse
- 40: Kühlkörper
- 45: Verbindungsschicht
- 50: erster Auffangbehälter
- 55: zweiter Auffangbehälter
- 60: Gehäuseinnenraum
- 65: Wärmequelle
- 70: Durchgangsöffnung
- 75: Gehäuseoberseite
- 80: Gehäuseunterseite
- 85: erste Seitenfläche
- 86: zweite Seitenfläche
- 86: dritte Seitenfläche
- 90: erstes Auffangvolumen
- 95: zweites Auffangvolumen
- 100: Spalt
- 105: Leiterplatte
- 110: erste Verbindungsseitenfläche
- 115: zweite Verbindungsseitenfläche
- 120: Sensoreinrichtung
- 125: erster Sensor
- 130: zweiter Sensor
- 135: Freifläche
- 145: Kanal
- 205: erster Verfahrensschritt
- 210: zweiter Verfahrensschritt
- 215: dritter Verfahrensschritt
- 220: vierter Verfahrensschritt
- 225: fünfter Verfahrensschritt
- 230: sechster Verfahrensschritt
- Q: Wärme

## Patentansprüche

1. Steuergerät (10) für ein Fahrzeug, insbesondere fahrzeuginterner Lader (15) für ein elektrisch angetriebenes Fahrzeug,
- aufweisend eine Steuereinrichtung (30) mit einer Wärmequelle (65), ein Gehäuse (35), einen Kühlkörper (40) und eine Verbindungsschicht (45),
- wobei in einem Gehäuseinnenraum (60) des Gehäuses (35) die Steuereinrichtung (30) angeordnet ist und an einer ersten Verbindungsseitenfläche (110) der Verbindungsschicht (45) anliegt,
- wobei der Kühlkörper (40) außerhalb des Gehäuseinnenraums (60) angeordnet ist und an einer zur ersten Verbindungsseitenfläche (110) gegenüberliegend angeordneten zweiten Verbindungsseitenfläche (115) der Verbindungsschicht (45) anliegt,
- wobei die Verbindungsschicht (45) thermisch und mechanisch die Steuereinrichtung (30) mit dem Kühlkörper (40) zur Kühlung der Wärmequelle (65) verbindet,
- wobei die Verbindungsschicht (45) ein Verbindungsmaterial aufweist, das ausgebildet ist, bei einer thermischen Überlastungder Steuereinrichtung (30) aus einem festen Phasenzustand aufzuschmelzen und die Steuereinrichtung (30) durch das Aufschmelzen vom festen Phasenzustand in einen flüssigen Phasenzustand zu kühlen.

2. Steuergerät (10) nach Anspruch 1,
- aufweisend einen ersten Auffangbehälter (50),
- wobei der erste Auffangbehälter (50) versetzt zu dem Kühlkörper (40) angeordnet ist und ein erstes Auffangvolumen (90) begrenzt,
- wobei der erste Auffangbehälter (50) auf der zur Verbindungsschicht (45) zugewandten Seite offen ausgestaltet und ausgebildet ist, aufgeschmolzenes Verbindungsmaterial der Verbindungsschicht (45) aufzunehmen.

3. Steuergerät (10) nach Anspruch 2,
- aufweisend eine Sensoreinrichtung (120) mit wenigstens einem ersten Sensor (125),
- wobei der erste Sensor (125) ausgebildet ist, das in dem ersten Auffangvolumen (90) befindliche Verbindungsmaterial zu erfassen und in Abhängigkeit des erfassten Verbindungsmaterials ein Sensorsignal bereitzustellen.

4. Steuergerät (10) nach Anspruch 3,
- wobei der erste Sensor (125) in dem ersten Auffangvolumen (90) oder außerhalb des ersten Auffangbehälters (50) angeordnet ist
- und/oder,
- wobei der erste Sensor (125) in die Verbindungsschicht (45) eingebettet ist.

5. Steuergerät (10) nach einem der vorhergehenden Ansprüche,
- wobei das Verbindungsmaterial der Verbindungsschicht (45) im Wesentlichen zerstörungsfrei reversibel aus dem festen Phasenzustand in den flüssigen Phasenzustand überführbar ist,
- wobei ein Schmelzpunkt des Verbindungsmaterials in einem Bereich von einschließlich 100°C bis einschließlich 280°C liegt.

6. Steuergerät (10) nach einem der vorhergehenden Ansprüche,
- wobei die Verbindungsschicht (45) wenigstens eines der folgenden Verbindungsmaterialien aufweist:
- aliphatischen Kohlenwasserstoff, vorzugsweise mit 16 oder 17 oder 18 Kohlenstoffatomen,
- Salz,
- mikroverkapseltes Hartparaffin,
- Hartparaffin,
- Wachs,
- Naturwachs,
- biologisch abbaubares Wachs
- oxidiertes Wachsen,
- Lipid,
- thermochemischen Wärmespeicher,
- wobei das Verbindungsmaterial recylingfähig ist,
- und/oder
- wobei die Verbindungsschicht (45) wenigstens eines der folgenden Versteifungsmaterialien aufweist, das in dem Verbindungsmaterial eingebettet ist:
- Aluminiumnitrid (AIN),
- merzerisierte Zellulose,
- pflanzliches Pulver,
- Kohlenstoff-Nanofilament,
- Zellulose-Nanofilament
- Nanocellulose
- Mikrofibrille,
- Nanofibrille,
- Glasfaser,
- Basaltfaser,
- Hanffaser,
- Flachs,
- Aramidfaser,
- Nylonfaser,
- Karbonfaser.

7. Steuergerät (10) nach einem der vorhergehenden Ansprüche,
- wobei das Gehäuse (35) eine Durchgangsöffnung (70) aufweist,
- wobei der Kühlkörper (40) an der Durchgangsöffnung (70) angeordnet ist und die Verbindungsschicht (45) die Durchgangsöffnung (70) fluidisch abdichtet, und/oder
- wobei der Kühlkörper (40), vorzugsweise ausschließlich, stoffschlüssig mittels der Verbindungsschicht (45) mechanisch an der Steuereinrichtung (30) befestigt ist,
- wobei die Steuereinrichtung (30) in dem Gehäuse (35) befestigt ist.

8. Steuergerät (10) nach einem der Ansprüche 2 bis 7,
- wobei der erste Auffangbehälter (50) zumindest abschnittweise die Durchgangöffnung (70) verschließt.

9. Steuergerät (10) nach einem der Ansprüche 2 bis 8,
- wobei das Gehäuse (35) eine Gehäuseunterseite (80) aufweist,
- wobei an der Gehäuseunterseite (80) der Kühlkörper (40) angeordnet ist,
- wobei die Verbindungsschicht (45) unterhalb an der Steuereinrichtung (30) angeordnet ist,
- wobei der Kühlkörper (40) unterhalb an der Verbindungsschicht (45) angeordnet ist,
- wobei der Kühlkörper (40) ausgebildet ist, bei einem Aufschmelzen des Verbindungsmaterials der Verbindungsschicht (45) sich zu lösen und sich von der Steuereinrichtung (30) zu trennen.

10. Steuergerät (10) nach einem der Ansprüche 2 bis 9,
- aufweisend einen zweiten Auffangbehälter (55) mit einem zweiten Auffangvolumen (95),
- wobei der zweite Auffangbehälter (55) versetzt zu dem ersten Auffangbehälter (50) und dem Kühlkörper (40) angeordnet ist,
- wobei der zweite Auffangbehälter (55) das zweite Auffangvolumen (95) begrenzt,
- wobei der zweite Auffangbehälter (55) auf der zur Verbindungsschicht (45) zugewandten Seite offen ausgestaltet und ausgebildet ist, aufgeschmolzenes Verbindungsmaterial der Verbindungsschicht (45) aufzunehmen.

11. Steuergerät (10) nach einem der vorhergehenden Ansprüche,
- wobei die Verbindungsschicht (45) eine Freifläche (135) aufweist, die auf einer der Steuereinrichtung (30) abgewandten Seite angeordnet ist,
- wobei die Freifläche (135) seitlich beabstandet zu dem Kühlkörper (40) und vorzugsweise dem ersten Auffangbehälter (50) angeordnet ist,
- wobei die Freifläche (135) unbedeckt ist
und/oder
- wobei das Verbindungsmaterial in flüssigem Phasenzustand zerstörungsfrei reversibel von der Steuereinrichtung (30) trennbar ist.

12. Steuergerät (10) nach einem der vorhergehenden Ansprüche,
- wobei nach der Trennung von der Steuereinrichtung (30) das Verbindungsmaterial wieder verwendbar ist.

13. Verfahren zur Herstellung eines Steuergeräts (10) nach einem der vorhergehenden Ansprüche,
- wobei die Steuereinrichtung (30) in den Gehäuseinnenraum (60) eingebracht wird,
- wobei das Verbindungsmaterial der Verbindungsschicht (45) in flüssigem Phasenzustand auf die Steuereinrichtung (30) aufgebracht wird,
- wobei der Kühlkörper (40) an dem flüssigen Verbindungsmaterial angeordnet wird und der Kühlkörper (40) das flüssige Verbindungsmaterial abkühlt, sodass das flüssige Verbindungsmaterial in den festen Phasenzustand zu der Verbindungsschicht (45) überführt wird und die Verbindungsschicht den Kühlkörper (40) mit der Steuereinrichtung (30) thermisch, und vorzugsweise mechanisch, verbindet.

14. Verfahren zum Betrieb eines Steuergeräts (10) nach einem der Ansprüche 2 bis 12,
- wobei in einem Regelbetrieb die Steuereinrichtung (30) mit der Wärmequelle (65) eine Wärme erzeugt,
- wobei im Regelbetrieb die Wärmequelle (65) eine erste Maximaltemperatur erreicht, die geringer ist als eine Schmelztemperatur des Verbindungsmaterials,
- wobei die Wärme über die Verbindungsschicht (45) von der Wärmequelle (65) zu dem Kühlkörper (40) zur Kühlung der Wärmequelle (65) abgeführt wird,
- wobei in einem Fehlerfall die Wärmequelle (65) sich auf eine zweite Maximaltemperatur erwärmt, die größer ist als die Schmelztemperatur des Verbindungsmaterials,
- wobei das Verbindungsmaterial aufschmilzt und in den flüssigen Phasenzustand überführt wird,
- wobei das flüssige Verbindungsmaterial in das erste Auffangvolumen (90) fließt.

15. Verfahren nach Anspruch 14,
- wobei ein Vorhandensein von Verbindungsmaterial in dem ersten Auffangvolumen (90) überprüft wird,
- wobei bei Erfassen von Verbindungsmaterial in dem ersten Auffangvolumen (90) das Steuergerät (10) deaktiviert wird.
